# EUROPÄISCHE PATENTSCHRIFT

(11) **EP 0 654 900 B1**
(45) Veröffentlichungstag und Bekanntmachung des Hinweises auf die Patenterteilung: **10.02.1999**
(21) Anmeldenummer: 94203303.6
(22) Anmeldetag: 14.11.1994
(51) Int. Cl.: H03G 3/30, H03G 3/20

(54) **Funkgerät mit Sendeleistungsregelung**
Radio communication device with power control of transmission
Appareil de radiocommunication avec commande de puissance d'émission

(30) Priorität: 19.11.1993 DE 4339526
(43) Veröffentlichungstag der Anmeldung: 24.05.1995
(73) Patentinhaber: Philips Patentverwaltung GmbH, 22335 Hamburg (DE); Koninklijke Philips Electronics N.V., 5621 BA Eindhoven (NL)
(72) Erfinder: Birth, Winfrid, Dipl.-Ing., c/o Philips, D-20097 Hamburg (DE); Saur, Erich, Dr., c/o Philips, D-20097 Hamburg (DE); Marshall, Christopher, Dr., c/o Philips, D-20097 Hamburg (DE)
(74) Vertreter: Volmer, Georg, Dipl.-Ing.

(56) Entgegenhaltungen:
- EP-A- 0 481 741
- DE-A- 3 940 295
- DE-C- 3 742 270
- US-A- 4 737 733
- PATENT ABSTRACTS OF JAPAN vol. 004 no. 175 (E-036) ,3.Dezember 1980 & JP-A-55 120232 (NEC CORP) 16.September 1980,

## Beschreibung

Die Erfindung betrifft ein Funkgerät mit einer Hochfrequenz-Endstufe und einer Regelschaltung zur Regelung der Sendeleistung, wobei der Regelschaltung als Istwert ein vom Sendesignal abgeleitetes Signal zugeführt ist.

Funkgeräte mit einer Anordnung zur Regelung der Sendeleistung werden immer dann benötigt, wenn die vom Funkgerät abgestrahlte Leistung sehr genau eingehalten werden muß. Dies ist der Fall beispielsweise in modernen zellularen Mobilfunksystemen, bei denen eine zentrale Basisstation je nach der Leistung, mit der die einzelnen Mobil stationen empfangen werden können, den Mobilstationen eine bestimmte Sendeleistung vorgibt. Auf diese Weise kann sichergestellt werden, daß die einzelnen, von den Mobil stationen ausgesendeten Signale unabhängig von der Entfernung zwischen Mobil station und Basisstation annähernd mit gleicher Signalstärke an der Basisstation eintreffen. Somit können gegenseitige Störungen durch übermäßig starke Signale vermieden werden, wodurch die Kapazität eines zellularen Mobilfunknetztes optimiert wird.

Beispielsweise aus DE 39 40 295 A1 ist ein Hochfrequenz-Sender mit geregelter Ausgangsleistung bekannt, bei dem ein Teil der Ausgangsleistung eines HF-Leistungsverstärkers durch einen am Ausgang des HF-Leistungsverstärkers liegenden Richtkoppler ausgekoppelt wird. Die ausgekoppelte HF-Leistung wird durch eine HF-Gleichrichterschaltung gleichgerichtet, in einem invertierenden Verstärker invertiert und einen Regelverstärker als Istwert zugeführt. Mittels eines Sollwertgebers wird entsprechend der gewünschten Ausgangsleistung dem Regelverstärker eine elektrische Spannung vorgegeben. Aus der Spannungsdifferenz zwischen Sollwertspannung und Istwertspannung erzeugt der Regelverstärker eine Stellspannung, die über einen Steuereingang einem HF-Treiberverstärker zugeführt ist. Der Ausgang des HF-Treiberverstärkers ist mit dem Eingang der HF-Endstufe verbunden, so daß auf diese Weise der Regelkreis geschlossen wird.

Durch die Auskoppelung der Istspannung am Ausgang des Endverstärkers können alle Nichtlinearitäten der HF-Endstufe kompensiert werden. Durch die immer weiter fortschreitende Miniaturisierung und Integration von Bauelementen begünstigt geht der Trend bei Mobilfunkgeräten zu Handfunkgeräten, die von ihren Benutzern bequem in einer Hand gehalten werden können. Die hierdurch ermöglichte Mobilität der Benutzer hat jedoch überraschenderweise dazu geführt, daß trotz Sendeleistungsregelung vermehrte Störungen zu beklagen waren.

Aufgrund ihres geringen Gewichts und ihrer geringen Baugröße werden Handfunkgeräte von ihren Benutzern in ständig wechselnder Position gehalten. Da die Antenne am Handfunkgerät angebracht ist, ändert sich hierdurch zwangsläufig ständig das Umfeld der Antenne wodurch sich ständig Fehlanpassungen der Antenne ergeben. Durch diese Fehlanpassungen kommt es zu einer Spannungsverminderung in dem Meßsensor, der am Richtkopplerausgang angeschlossen ist. Zur Kompensation des vermeintlichen Leistungsabfalls der Hochfrequenzendstufe erhöht die Regelschaltung die Verstärkung und steuert so die Hochfrequenzendstufe in die Sättigung. Durch die Sättigung der Regelstrecke beziehungsweise der Hochfrequenzendstufe verschlechtert sich das Ausgangsspektrum eines TDMA-(time division multiple access) Senders beim Durchlaufen der ansteigenden bzw. abfallenden Flanke der Signalbursts so stark, daß es durch Nebenausstrahlungen zu Störungen der Nachbarkanäle kommt.

Aufgabe der Erfindung ist es, bei Funkgeräten der eingangs genannten Art, insbesondere tragbaren Handfunkgeräten Störungen des Ausgangsspektrums zu vermeiden.

Aus US 4,737,733 ist eine Leistungsendstufe für ein Satelittenkommunikationssystem bekannt, bei dem zur Sendeleistungsregelung einer Regelschaltung das Eingangssignal der Leistungsendstufe zugeführt ist und das Ausgangssignal der Regelschaltung dazu verwendet wird, um mittels eines PIN-Dioden-Dämpfungsgliedes das Eingangssignal von der Leistungsendstufe vorgelagerten Verstärkerstufen abzuschwächen. Der zwischen Regelschaltung und Eingang der Leistungsendstufe zwischengeschaltete Sensorverstärker erfüllt hierbei lediglich den Zweck, für eine ausreichende Verstärkung des der Regelschaltung zugeführten Signals zu sorgen. Aus EP 0 481 741 A3 ist desweiteren ein HF-Leistungsverstärker für ein Mobilfunkgerät bekannt, bei dem ein Teil der Ausgangsleistung der Leistungsendstufe über einen Richtkoppler abgegriffen wird und einer Regelschaltung zugeführt ist. Die Hochfrequenzstufe dieses Mobilfunkgerätes besteht hierbei aus mehreren Treibervorstufen und einer Leistungsendstufe, die als Hybridschaltung ausgestaltet sind.

Ein weiterer Aspekt der Erfindung ist es bei Handfunkgeräten Volumen einzusparen und durch Verminderung der Leistungsaufnahme die Batteriestandzeit zu erhöhen.

Diese Aufgabe wird durch die Merkmale des Anspruchs 1 bzw. des Anspruchs 2 gelöst.

Mit dem neuen Schaltungskonzept ist die Leistungsregelungunabhängig von der Antennenanpassung an der Sendeendstufe. Auf diese Weise ist sichergestellt, daß das Störspektrum stets innerhalb des zulässigen Bereichs bleibt. Ein zur Auskoppelung eventuell benötigter Trennverstärker weist einen erheblich geringeren Platzbedarf auf als der bisher übliche Richtkoppler. Außerdem fällt die Einfügungsdämpfungdes Richtkopplers (ca. 1 bis 3 dB) weg, so daß die zum Ausgleich der Einfügungsdämpfung erforderliche Leistungsanhebung der Endstufe ebenfalls entfällt und so der Stromverbrauch im Sendebetrieb reduziert wird. Somit eignet sich die erfindungsgemäße Schaltung im besonderen für Handfunkgeräte.

Die Erfindung wird nun anhand eines in den Zeichnungen dargestellten Ausführungsbeispiels näher beschrieben.

Es zeigen:
- Fig. 1: allgemeines Blockschaltbild eines Funkgerätes,
- Fig. 2: Ausschnitt aus der Sendeendstufe eines Funkgerätes.

Das Ausführungsbeispiel zeigt ein Mobilfunkgerät für Zeitschlitz-Mehrfachzugriffsbetrieb (TDMA = time division multiple access) bei dem zu sendende und zu empfangende Signale zeitkomprimiert als Datenpakete zu jeweils unterschiedlichen Zeitpunkten gesendet bzw. empfangen werden. Hierzu genügt eine gemeinsame Antenne 1, welche über einen Antennenumschalter 2 wahlweise mit einem Empfangsteil 3 oder einem Sendeteil 4 des Funkgerätes verbunden wird. Zur Steuerung des Antennenumschalter 2 als auch des Empfangsteils 3 und des Sendeteils 4 ist eine Steuerschaltung 5 vorgesehen. In üblicher Weise wird das empfangene Signal 3 soweit aufbereitet, daß es über einen Lautsprecher wiedergegeben wird. Gesprochene Signale werden von einem Mikrophon 7 aufgenommen und ebenfalls in bekannter Weise vom Sendeteil 4 verarbeitet. Insbesondere enthält der Sendeteil einen Niederfrequenzteil zur Verstärkung des Mikrophonsignals, einen Codierungsteil zur Datenreduktion des Mikrophonsignals, einen oder mehrere Oszillatoren zur Erzeugung eines Trägersignals, einen Modulator mittels welchem auf das Trägersignal das zeitkomprimierte Sprechsignal aufgebracht wird und eine Sendeendstufe, welche zur Leistungsverstärkung und Leistungsregelung des zu sendenden Signals dient.

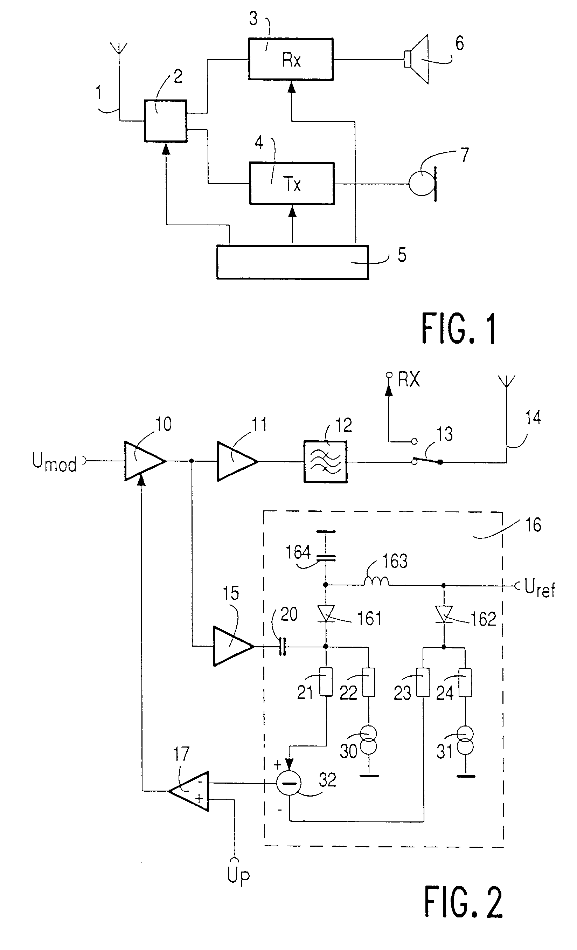

In Fig. 2 ist als bevorzugte Ausführungsform nur die Sendeendstufe dargestellt die die Erfindung enthält. Ein Modulationsignal U_{mod} ist einem steuerbaren HF-Treiberverstärker 10 zugeführt. Der steuerbare HF-Treiberverstärker 10 weist einen Steuereingang auf. Die Ausgangsamplitude des steuerbaren HF-Verstärkers wird in Abhängigkeit von der an seinem Steuereingang anliegenden Steuerspannung eingestellt.

Der Ausgang des steuerbaren HF-Treiberverstärkers 10 ist mit einer HF-Leistungsendstufe 11 mit konstanter Leistungsverstärkung verbunden. Über ein HF-Ausgangsfilter 12 wird das Ausgangssignal der HF-Endstufe 11 über einen Schaltkontakt eines Antennenumschalters 13 an eine Antenne 14 geführt. Der Antennenumschalter 13 ist in Fig. 2 in der Schaltstellung des Sendebetriebs gezeichnet. Im Empfangsbetrieb befindet sich der Antennenumschalter 13 in der anderen Schaltstellung, so daß das Antenneneingangssignal zur Empfangsstufe RX geführt wird.

Zur Leistungsregelung wird das Eingangssignal der HF-Leistungsendstufe 11 außerdem über einen Trennverstärker dämpfungsfrei ausgekoppelt. Wegen seiner Funktion einen zur HF-Leistung proportionalen Wert abzuleiten und gleichzeitig für die nachfolgende Anordnung zur HF-Gleichrichtung 16 eine ausreichende Leistung bereitzustellen wird dieser Trennverstärker im folgenden als Sensortreiberverstärker 15 bezeichnet. Das durch den Sensortreiberverstärker 15 verstärkte HF-Signal wird vom Koppelkondensator 20 an die Kathode einer HF-Gleichrichterdiode 161 geführt. Zwischen Anode der HF-Gleichrichterdiode 161 und Masse liegt ein zweiter Kondensator 164. Das gleichgerichtete HF-Signal wird über einen ersten Koppelwiderstand 21 zu einem Summierverstärker 32 geführt. Zur Erzeugung einer Gleichstromvorspannung ist der Gleichrichterdiode 161 über eine HF-Drossel 163 mit einer Vergleichs spannung U_{ref} verbunden. Der Gleichstrom fließt über die Gleichrichterdiode 161 und einem zweiten Widerstand 22 zu einer ersten Stromquelle 30. Zur Kompensation der Diodenvorspannung ist bis auf die Einkoppelung des HF-Signals ein identischer Diodenzweig aufgebaut, dessen Ausgangsspannung im Summierverstärker 32 von der Ausgangsspannung der Gleichrichterdiode 161 subtrahiert wird, so daß als Ausgangssignal des Summierverstärkers 32 nur noch die gleichgerichtete HF-Spannung übrig bleibt. Vorzugsweise wird als Kompensationsdiode 162 die gleiche Diode gewählt, wie die HF-Gleichrichterdiode 161. Die Kompensationsdiode 162 ist mit ihrer Anode ebenfalls an der Vergleichsspannung U_{ref} angeschlossen. Die Katode der Kompensationsdiode 162 ist über einen dritten Widerstand 23 mit dem invertierenden Eingang des Summierverstärkers verbunden. Ferner ist die Katode der Kompensationsdiode 162 über einen vierten Widerstand 24 mit einer zweiten Konstantstromquelle 31 verbunden. Für eine ideale Gleichspannungskompensation ist es erforderlich, daß die Widerstandswerte von ersten Widerstand 21 und dritten Widerstand 23 als auch von zweiten Widerstand 22 und vierten Widerstand 24 paarweise gleich gewählt sind. Ferner sind natürlich auch die bei den Stromquellen 30 und 31 so zu wählen, daß sie gleiche Konstantströme aufweisen.

Der Ausgang des Summierverstärkers 32 ist dem invertierenden Eingang eines Regelverstärkers 17 zugeführt. Den nichtinvertierenden Eingang des Regelverstärkers 17 ist eine Steuerspannung Uₚ zugeführt. Die Differenz der beiden Spannungen ergibt die zur Ansteuerung des steuerbaren HF-Vorverstärkers 10 benötigte Steuerspannung. Auf diese Weise ist der Regelkreis geschlossen. Weitere, dem Fachmann bekannte Elemente des Regelkreises wie beispielsweise Filter und Offsetkompensationsschaltungen sind aus Gründen der Übersichtlichkeit in Figur 2 nicht enthalten.

Mit Hilfe der Steuerspannung Uₚ wird die gewünschte Ausgangsleistung vorgegeben. Insbesondere bei der Erzeugung der ansteigenden und abfallenden Flanke des TDMA-Signals kann hier durch die Steuerschaltung 5 der Signalverlauf der Flanken vorgegeben werden. Durch die weitgehende Entkoppelung des Ausgangs der HF-Leistungsendstufe 11 von dem Ausgangssignal des Sensortreiberverstärkers 15 ist sichergestellt, daß Fehlanpassungen der Antenne keine Rückwirkung auf die Steuerspannung Uₚ des Treiberverstärkers 10 hat. Damit ist erreicht, daß das Spektrum des TDMA-Signals stets unabhängig von der Anpassung der Sende-Endstufe von gleichbleibender Qualität bleibt.

Durch den Wegfall des Richtkopplers läßt sich die erfindungsgemäße Schaltung vollständig in ein Monolithic Microwave Integrated Circuit (MMIC), z. B. auf Gallium-Arsenid-Basis integrieren. Der Platzbedarf der im Stand der Technik sonst üblichen Richtkopplerstruktur von 4 bis 5 cm Ausdehnung in der Länge kann auf diese Weise vollständig eingespart werden.

Ein wichtiger Gesichtspunkt für eine gute Regelgenauigkeit beispielsweise in Bezug auf Temperatur, Spannungsschwankungen und Fertigungstoleranzen ist es, daß jede Veränderung der Verstärkung der Hochfrequenz-Endstufe 11 annäherd durch eine Veränderung der Verstärkung des Trennverstärkers 15 ausgeglichen wird. Die Ausgangsleistungen von Hauptverstärker und Trennverstärker sind dann miteinander gut korreliert, so daß die Regelung des Ausgangs des Trennverstärkers zu einer genauen Regelung des Hauptausgangs führt. Eine nahe Übereinstimmung von Haupt- und Trennverstärker kann dadurch erreicht werden, daß beide zusammen auf einem gemeinsamen integrierten Schaltkreis implementiert sind (beispielsweise Silizium oder Gallium Arsenid), wodurch die durch diese Techologien bewirkten Möglichkeiten einer excellenten Bauteileübereinstimmung ausgenutzt werden.

## Patentansprüche

1. TDMA-Funkgerät mit einer Hochfrequenz-Endstufe (11) und einer Regelschaltung (16, 17) zur Regelung der Sendeleistung, wobei der Regelschaltung (16, 17) als Istwert ein vom Sendesignal abgeleitetes Signal zugeführt ist und die Regelschaltung (16, 17) den Eingangssignalpegel der HF-Endstufe (11) verstellt,
dadurch gekennzeichnet,
daß ein Sensortreiberverstärker (15) vorgesehen ist, dem das ausgekoppelte Eingangssignal der HF-Leistungsendstufe (11) zugeführt ist, und der derart dimensioniert ist, daß sein Ausgangssignal eine Leistung aufweist, das der Ausgangsleistung der HF-Leistungsendstufe proportional ist und das der Regelschaltung (16,17) als Ist-Wert zugeführt ist, wobei mindestens die HF-Leistungsendstufe (11) und der Sensortreiberverstärker (15) zusammen in einem Integrierten Schaltkreis integriert sind.

2. Integrierter Schaltkreis für TDMA-Funkgeräte mit einem steuerbaren HF-Treiberverstärker (10), einer HF-Leistungsendstufe (11) und einem Sensortreiberverstärker (15) dem das auskoppelte Eingangssignal der HF-Leistungsendstufe (11) zugeführt ist, und der derart dimensioniert ist, daß sein Ausgangssignal eine Leistung aufweist, das der Ausgangsleistung der HF-Leistungsendstufe (11) proportional ist und das einer Regelschaltung (16;17) als Ist-Wert zur Regelung der Sendeleistung zuführbar ist.

3. Funkgerät bzw. Integrierter Schaltkreis nach Anspruch 1 oder 2,
dadurch gekennzeichnet,
daß der Integrierte Schaltkreis in Gallium-Arsenid-Technik gefertigt ist.

## Claims

1. A TDMA transceiver having a high-frequency power output stage (11) and a control circuit (16, 17) for controlling the transmitter power, in which the control circuit (16, 17) is supplied with an actual voltage in the form of a signal derived from the transmit signal and the control circuit (16, 17) changes the input signal level of the HF power output stage (11), characterized in that a sensor driver amplifier (15) is provided which is supplied with the extracted input signal of the HF power output stage and which is dimensioned such that its output signal contains a power that is proportional to the output power of the HF power output stage and which is applied to the control circuit (16, 17) as an actual voltage while at least the HF power output stage (11) and the sensor driver amplifier (15) are together integrated with an integrated circuit.

2. An integrated circuit for TDMA radio transceivers having a controllable HF driver amplifier (10), a HF power output stage (11) and a sensor driver amplifier (15) which is supplied with the extracted input signal of the HF power output stage (11) and which is dimensioned such that its output signal has a power that is proportional to the output power of the HF power output stage (11) and which can be applied to a control circuit (16, 17) as an actual voltage for controlling the transmitter power.

3. A radio transceiver and integrated circuit respectively, as claimed in claim 1 or 2, characterized in that the integrated circuit is manufactured in Gallium Arsenide technology.

## Revendications

1. Appareil de radiocommunication TDMA avec un étage final à haute fréquence (11) et un circuit de réglage (16, 17) en vue du réglage de la puissance de transmission, un signal dérivé du signal de transmission étant amené au circuit de réglage (16, 17) comme valeur réelle et le circuit de réglage (16, 17) réglant le niveau du signal d'entrée de l'étage final HF (11),
caractérisé en ce
qu'il est prévu un amplificateur d'attaque capteur (15) auquel est amené le signal d'entrée déclenché de l'étage final de puissance HF (11) et qui est dimensionné de telle sorte que son signal de sortie présente une puissance qui est proportionnelle à la puissance de sortie de l'étage final de puissance HF et est amenée comme valeur réelle au circuit de réglage (16, 17), l'étage final de puissance HF (11) et l'amplificateur d'attaque du capteur (15) étant au moins intégrés ensemble dans un circuit de commutation intégré.

2. Circuit intégré pour les appareils de radiocommunication TDMA avec un amplificateur d'attaque HF susceptible d'être commandé (10), un étage final de puissance HF (11) et un amplificateur d'attaque du capteur (15) auquel est amené le signal d'entrée déclenché de l'étage final de puissance HF (11) et qui est dimensionné de telle sorte que son signal de sortie présente une puissance qui est proportionnelle à la puissance de sortie de l'étage final de puissance HF (11) et qui peut être amenée à un circuit de réglage (16, 17) comme valeur réelle en vue du réglage de la puissance de transmission.

3. Appareil de radiocommunication ou circuit intégré selon l'une des revendications 1 ou 2,
caractérisé en ce que le circuit intégré est fabriqué dans une technique d'arséniure de gallium.
